# EUROPEAN PATENT APPLICATION

(11) **EP 4 679 703 A1**
(43) Date of publication of application: **14.01.2026**
(21) Application number: 24792593.6
(22) Date of filing: 11.04.2024
(51) Int. Cl.: H02M 7/48

(54) **POWER SEMICONDUCTOR MODULE AND POWER CONVERSION DEVICE**

(30) Priority: 17.04.2023 JP 2023067043
(71) Applicant: IHI Corporation, Tokyo 135-8710 (JP)
(72) Inventor: NOTAKE, Koki, Tokyo 135-8710 (JP)
(74) Representative: TBK
(86) International application number: PCT/JP2024/014693
(87) International publication number: WO 2024/219318

(57) **Abstract**

A power semiconductor module includes a power semiconductor element, a first power line portion and a second power line portion respectively electrically connected to a first electrode and a second electrode of the power semiconductor element, a heat dissipation plate capable of dissipating heat from the power semiconductor element, a sensor element mounted on a front surface of the heat dissipation plate, and a first sensor line portion and a second sensor line portion electrically connected to the sensor element. The heat dissipation plate has at least one through-hole passing through between the front surface and a rear surface. The first sensor line portion and the second sensor line portion are drawn out to a region on the rear surface of the heat dissipation plate through the through-hole.

## Description

### Technical Field

The present disclosure relates to a power semiconductor module and a power conversion device.

### Background Art

Patent Literatures 1 and 2 disclose a technology relating to a power semiconductor module that is used in a power conversion device and the like. The Patent Literatures disclose that a shunt resistor (shunt resistance) configured to detect an electric current output from the power semiconductor device is provided inside the power semiconductor module.

### Citation List

### Patent Literature

Patent Literature 1: Japanese Unexamined Patent Publication No. 09-65662
Patent Literature 2: Japanese Patent No. 4236909

### Summary of Invention

### Technical Problem

The output voltage required for the power conversion device as described above is increasing. As the output voltage increases, a voltage applied to a module element also increases. As a result, a radiation noise (radiated noise, electromagnetic noise) radiated from a wire or the like connected to the module element also increases. On the other hand, a detection signal of a sensor element such as the shunt resistor provided in the power semiconductor module is weaker as compared with the voltage applied to the power semiconductor element. Therefore, when a large radiation noise radiated from a wire connected to a power semiconductor element or the like propagates to a terminal connected to the sensor element such as the shunt resistor, detection accuracy of the sensor element decreases due to an influence of the noise.

Here, the present disclosure describes a power semiconductor module and a power conversion device capable of suppressing the detection signal of the sensor element from being affected by the radiation noise.

### Solution to Problem

A power semiconductor module according to an aspect of the present disclosure includes a power semiconductor element that includes a first electrode, a second electrode, and a control electrode, and alternately switches conduction and non-conduction between the first electrode and the second electrode in response to a control signal applied to the control electrode; a first power line portion and a second power line portion respectively electrically connected to the first electrode and the second electrode, and transmit electric power between the first electrode and the second electrode; a heat dissipation plate that has a front surface on which the power semiconductor element is mounted, and a rear surface opposite to the front surface, and is configured to dissipate heat from the power semiconductor element; a sensor element mounted on the front surface of the heat dissipation plate; and a first sensor line portion and a second sensor line portion electrically connected to the sensor element, in which the heat dissipation plate includes a shield layer made of a material having at least one of electrical conductivity and magnetism, the heat dissipation plate has at least one through-hole passing through between the front surface and the rear surface, and among the first power line portion, the second power line portion, the first sensor line portion, and the second sensor line portion, only the first sensor line portion and the second sensor line portion are drawn out to a region on the rear surface of the heat dissipation plate through the through-hole.

### Advantageous Effects of Invention

According to various aspects of the present disclosure, it is possible to suppress the detection signal of the sensor element from being affected by the radiation noise.

### Brief Description of Drawings

[FIG. 1] FIG. 1 is a circuit diagram illustrating a power conversion device including a power semiconductor module of an embodiment.
[FIG. 2] FIG. 2 is a cross-sectional view illustrating the power semiconductor module of the power conversion device in FIG. 1.
[FIG. 3] FIG. 3 is a plan view of the power semiconductor element of the power semiconductor module in FIG. 2 as viewed from above.
[FIG. 4] FIG. 4 is a plan view of a shunt resistor of the power semiconductor module in FIG. 2 as viewed from above.
[FIG. 5] FIG. 5 is a cross-sectional view illustrating a power semiconductor module of a comparative example in a simplified manner.
[FIG. 6] FIG. 6 is a cross-sectional view illustrating the power semiconductor module in FIG. 2 in a simplified manner.
[FIG. 7] FIG. 7 is a cross-sectional view illustrating a power semiconductor module of Modification Example 1.
[FIG. 8] FIG. 8 is a plan view when a shunt resistor of the power semiconductor module in FIG. 7 is viewed from an upward side.
[FIG. 9] FIG. 9 is a cross-sectional view illustrating a power semiconductor module of Modification Example 2.
[FIG. 10] FIG. 10 is a cross-sectional view illustrating a power semiconductor module of Modification Example 3.
[FIG. 11] FIG. 11 is a plan view when a shunt resistor of the power semiconductor module in FIG. 10 is viewed from an upward side.
[FIG. 12] FIG. 12 is a cross-sectional view illustrating a power semiconductor module of Modification Example 4.
[FIG. 13] FIG. 13 is a cross-sectional view illustrating a power semiconductor module of Modification Example 5.
[FIG. 14] FIG. 14 is a cross-sectional view illustrating a power semiconductor module of Modification Example 6.

### Description of Embodiments

A power semiconductor module according to an aspect of the present disclosure includes: a power semiconductor element that includes a first electrode, a second electrode, and a control electrode, and alternately switches conduction and non-conduction between the first electrode and the second electrode in response to a control signal applied to the control electrode; a first power line portion and a second power line portion respectively electrically connected to the first electrode and the second electrode, and transmit electric power between the first electrode and the second electrode; a heat dissipation plate that has a front surface on which the power semiconductor element is mounted, and a rear surface opposite to the front surface, and is configured to dissipate heat from the power semiconductor element; a sensor element mounted on the front surface of the heat dissipation plate; and a first sensor line portion and a second sensor line portion electrically connected to the sensor element, in which the heat dissipation plate includes a shield layer made of a material having at least one of electrical conductivity and magnetism, the heat dissipation plate has at least one through-hole passing through between the front surface and the rear surface, and among the first power line portion, the second power line portion, the first sensor line portion, and the second sensor line portion, only the first sensor line portion and the second sensor line portion are drawn out to a region on the rear surface of the heat dissipation plate through the through-hole.

In the power semiconductor module, conduction and non-conduction between the first electrode and the second electrode are alternately switched in response to the control signal input to the control electrode. High electric power is applied to the first electrode and the second electrode in a conduction state, and according to this, a large radiation noise is radiated from the first power line portion and the second power line portion which are respectively connected to the first electrode and the second electrode. In the power semiconductor module, among the first power line portion, the second power line portion, the first sensor line portion, and the second sensor line portion, only the first sensor line portion and the second sensor line portion are drawn out to a region on the rear surface of the heat dissipation plate through the at least one through-hole of the heat dissipation plate. In addition, the heat dissipation plate includes the shield layer made of a material having at least one of electrical conductivity and magnetism. Therefore, it is possible to shield the radiation noise radiated from the first power line portion and the second power line portion by the heat dissipation plate. Accordingly, in the power semiconductor module, the first power line portion and the second power line portion of the region on the front surface of the heat dissipation plate, and the first sensor line portion and the second sensor line portion of the region on the rear surface of the heat dissipation plate are separated from each other by the heat dissipation plate, and the radiation noise is suppressed from propagating from the first power line portion and the second power line portion to the first sensor line portion and the second sensor line portion through the heat dissipation plate. In this way, it is possible to suppress the large radiation noise radiated from the first power line portion and the second power line portion from propagating to the first sensor line portion and the second sensor line portion connected to the sensor element by using the heat dissipation plate as a shield plate that shields the radiation noise. According to this, the power semiconductor module can suppress a detection signal of the sensor element from being affected by the radiation noise.

In the power semiconductor module, the sensor element may be a shunt resistor for current measurement, and may be electrically connected in series to a middle portion of the second power line portion. As described above, high electric power is applied to the first electrode and the second electrode in a conduction state. On the other hand, as the shunt resistor for detecting an electric current output from the power semiconductor element, a shunt resistor with a small resistance value is used for suppressing the amount of heat generation. According to this, a voltage on both ends of the shunt resistor to be measured for detecting the electric current output from the power semiconductor element is significantly lower than a high voltage applied to the power semiconductor element. Even in a case of using the shunt resistor, in the power semiconductor module, it is possible to suppress a detection signal of the shunt resistor (a voltage value of both ends of the shunt resistor) from being affected by the radiation noise. According to this, in the power semiconductor module, the output electric current can be measured with more accuracy by the shunt resistor.

In the power semiconductor module, the shunt resistor may be mounted on the front surface of the heat dissipation plate, and the heat dissipation plate may be capable of dissipating heat from the shunt resistor. When electric current flows through the shunt resistor, the shunt resistor generates heat. Even in this case, the power semiconductor module can shield the radiation noise while dissipating heat from the shunt resistor that generates heat by the heat dissipation plate.

In the power semiconductor module, the at least one through-hole may be formed at a position that does not overlap the first power line portion and the second power line portion in a plan view of the heat dissipation plate. In this case, the power semiconductor module can suppress the radiation noise radiated from the first power line portion and the second power line portion from propagating to the rear surface of the heat dissipation plate through the through-hole.

In the power semiconductor module, the heat dissipation plate may have the one through-hole, and the first sensor line portion and the second sensor line portion may be drawn out to the region on the rear surface through the one through-hole. In this way, since the first sensor line portion and the second sensor line portion collectively pass through the one through-hole, a distance between the first sensor line portion and the second sensor line portion becomes short, and according to this, an area of a loop formed by the first sensor line portion and the second sensor line portion is reduced. In this way, when the area of the loop is reduced, an electromotive force generated when the electromagnetic wave (radiation noise) interlinks the loop can be reduced. According to this, the power semiconductor module can reduce a risk in which a large conduction noise is generated in the first sensor line portion and the second sensor line portion.

In the power semiconductor module, the first sensor line portion and the second sensor line portion may be drawn out to the region on the rear surface through the one through-hole in a state of being twisted with each other. In this case, even though the radiation noise radiated from the first power line portion and the second power line portion propagates to the first sensor line portion and the second sensor line portion, a conduction noise generated in the first sensor line portion and the second sensor line portion and a conduction noise generated in a twisted portion operate to cancel each other. Therefore, the power semiconductor module can reduce a risk in which a large conduction noise is generated in the first sensor line portion and the second sensor line portion.

In the power semiconductor module, the first sensor line portion and the second sensor line portion may include a common mode filter or a transformer capable of removing a common mode component of the conduction noise conducting through the first sensor line portion and the second sensor line portion, and the common mode filter or the transformer may be disposed inside the one through-hole. In this case, since the common mode component of the conduction noise that may occur in the first sensor line portion and the second sensor line portion can be removed, it is possible to suppress occurrence of a fluctuation of a detection signal of the sensor element which is caused by the common mode component. In addition, since the common mode filter or the transformer is disposed inside the through-hole of the heat dissipation plate, it is possible to suppress propagation of the radiation noise from the first power line portion and the second power line portion to the first sensor line portion and the second sensor line portion through the common mode filter or the transformer.

The power semiconductor module may further include a cylindrical electromagnetic shield that is disposed to surround the first sensor line portion between an end on a sensor element side in the first sensor line portion and an opening of the one through-hole on the surface, and includes a shield layer made of a material having at least one of electrical conductivity and magnetism. In this case, the power semiconductor module can shield the radiation noise radiated from the first power line portion and the second power line portion by the electromagnetic shield. According to this, the power semiconductor module can suppress propagation of the radiation noise to the first sensor line portion inside the electromagnetic shield.

In the power semiconductor module, the heat dissipation plate may have a first through-hole and a second through-hole formed at different positions on the front surface as the through-hole, the first sensor line portion may be drawn out to the region on the rear surface through the first through-hole, and the second sensor line portion may be drawn out to the region on the rear surface through the second through-hole. In this case, the first sensor line portion and the second sensor line portion can respectively reach the first through-hole and the second through-hole in the shortest distances. According to this, since portions of the first sensor line portion and the second sensor line portion which are exposed to the inside of a casing through which the radiation noise propagates can be minimized, it is possible to reduce a risk in which the radiation noise propagates to the first sensor line portion and the second sensor line portion at the inside of the casing.

In the power semiconductor module, the at least one through-hole may be formed at a position overlapping the sensor element in a plan view of the heat dissipation plate. In this case, in the power semiconductor module, the first sensor line portion and the second sensor line portion can reach the through-hole in the shortest distance. According to this, since portions of the first sensor line portion and the second sensor line portion which are exposed to the inside of a casing through which the radiation noise propagates can be minimized, it is possible to reduce a risk in which the radiation noise propagates to the first sensor line portion and the second sensor line portion at the inside of the casing.

The power semiconductor module may further include a cover configured to cover the front surface of the heat dissipation plate on which the power semiconductor element is mounted, and the first power line portion and the second power line portion may extend toward the cover from the first electrode and the second electrode, and may be drawn out through the cover to the outside of the region covered with the cover. The cover may include a side wall portion, and a top plate facing the front surface with the side wall portion interposed between the front surface and the top plate, and the first power line portion and the second power line portion may extend toward the top plate from the first electrode and the second electrode, and may be drawn out through the top plate to the outside of the region covered with the cover. In this configuration, the first sensor line portion and the second sensor line portion can be drawn out to an opposite side of the first power line portion and the second power line portion. According to this, it is possible to more effectively suppress propagation of the radiation noise from the first power line portion and the second power line portion to the first sensor line portion and the second sensor line portion.

A power conversion device according to another aspect of the present disclosure includes: a power conversion unit that includes any one of the power semiconductor modules described above, and converts a first power mode supplied from a power source to a second power mode required for a load device; and a controller configured to transmit a control signal to the power semiconductor module based on a detection signal of the sensor element. The power conversion device provided in the power conversion device includes any one of the power semiconductor modules described above. According to this, the power conversion device can control the power conversion unit based on the detection signal of the sensor element that is suppressed from being affected by the radiation noise.

Hereinafter, the power semiconductor module and the power conversion device of the present disclosure will be described in detail with reference to the accompanying drawings. In description of the drawings, the same reference numeral will be given to the same elements, and redundant description will be omitted.

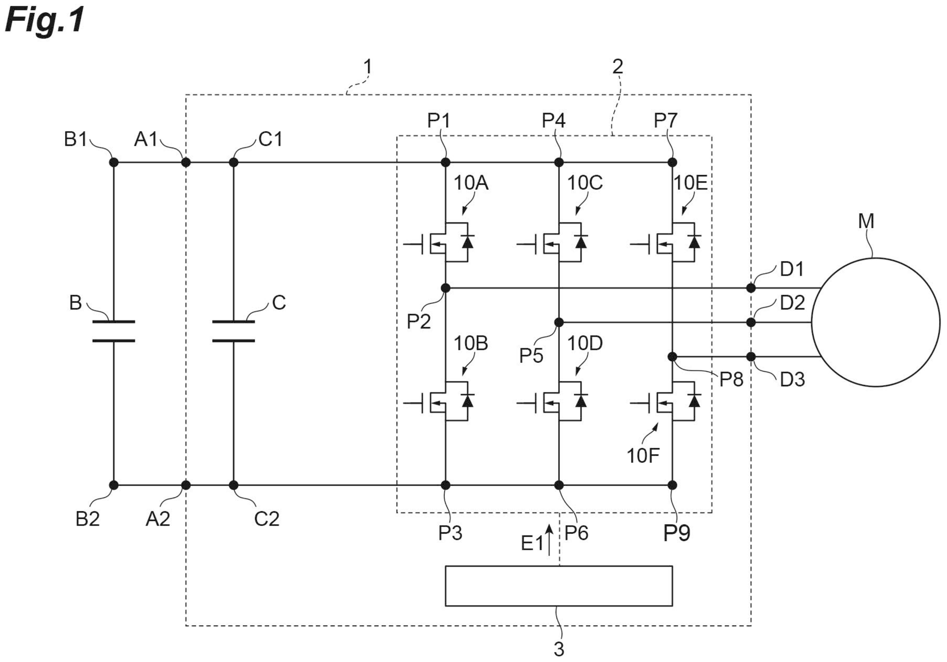

A power conversion device 1 shown in FIG. 1 converts electric power received from a power source B into electric power required for a load device M. For example, the power source B outputs DC electric power. The power source B includes a power source positive electrode terminal B1 and a power source negative electrode terminal B2. The load device M is, for example, a three-phase AC electric motor. The three-phase AC electric motor may be used as a power source that rotates an impeller. The power conversion device 1 may be used as an electric component such as an electric compressor or an electric blower. The electric compressor may be mounted, for example, on a mobile body such as a vehicle.

The power conversion device 1 in this embodiment converts DC electric power to AC electric power. That is, in this embodiment, DC electric power is exemplified as a first power mode and AC electric power is exemplified as a second power mode. The power conversion device 1 may be an inverter in a narrow sense. The power conversion device 1 may convert the AC electric power into the DC electric power. That is, the power conversion device 1 may be a converter. The power conversion device 1 may convert DC electric power in a first mode into DC electric power in a second mode.

The power conversion device 1 includes a positive electrode terminal A1 and a negative electrode terminal A2 as input terminals. The positive electrode terminal A1 is connected to the power source positive electrode terminal B1. The negative electrode terminal A2 is connected to the power source negative electrode terminal B2. The power conversion device 1 includes an output terminal D1, an output terminal D2, and an output terminal D3 as output terminals. The output terminals D1, D2, and D3 are connected to the load device M. For example, the output terminals D1, D2, and D3 correspond to a U-phase, a V-phase, and a W-phase of the three-phase AC electric motor, respectively.

The power conversion device 1 includes a capacitor C and a switch circuit 2 (power converter, power conversion unit) as an electrical constituent element. The capacitor C is connected between the power source B and the load device M. The capacitor C is, for example, a DC capacitor. A positive electrode terminal C1 of the capacitor C is connected to the power source positive electrode terminal B1. A negative electrode terminal C2 of the capacitor C is connected to the power source negative electrode terminal B2. The switch circuit 2 is connected between the capacitor C and the load device M. The switch circuit 2 converts DC electric power to pseudo AC electric power. The switch circuit 2 includes power semiconductor elements 10A to 10F as a switch, and connection points P1 to P9.

The connection points P1, P4, and P7 are connected to the positive electrode terminal C1 of the capacitor C. The connection points P3, P6, and P9 are connected to the negative electrode terminal C2 of the capacitor C. The connection points P2, P5, and P8 are respectively connected to the output terminals D1, D2, and D3. The power semiconductor element 10A is connected to the connection points P1 and P2. The power semiconductor element 10B is connected to the connection points P2 and P3. The connection points P1, P2, and P3, and the power semiconductor elements 10A and 10B form a first leg. Similarly, the connection points P4, P5, and P6, and the power semiconductor elements 10C and 10D form a second leg. The connection points P7, P8, and P9, and the power semiconductor elements 10E and 10F form a third leg.

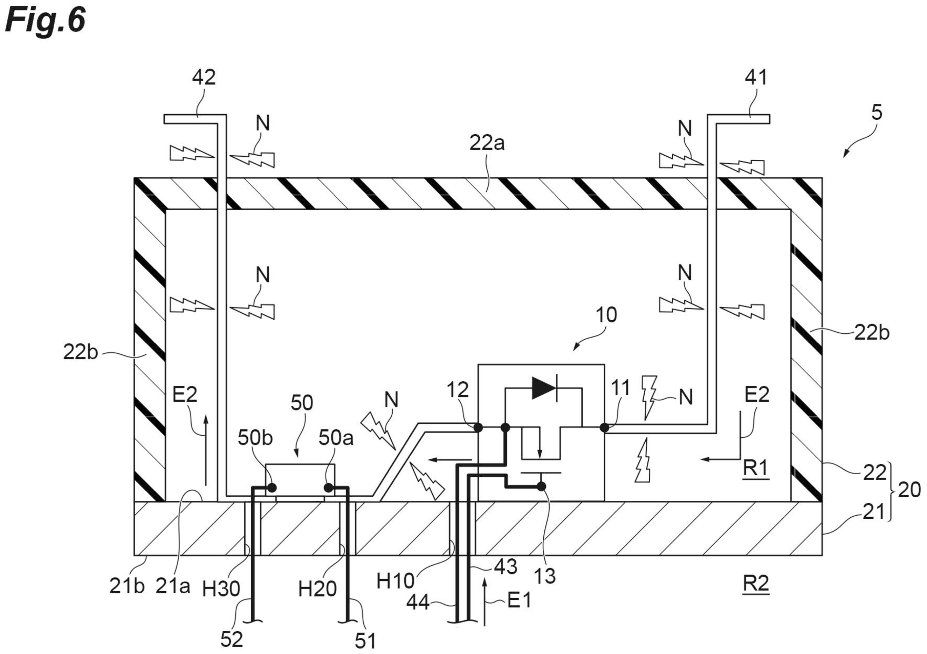

Each of the power semiconductor elements 10A to 10F is, for example, a semiconductor switch such as a metal oxide semiconductor field effect transistor (MOSFET) or an insulated gate bipolar transistor (IGBT). The power semiconductor elements 10A to 10F are electrically connected to a control substrate 3 (controller). The power semiconductor elements 10A to 10F are turned on or off in response to a control signal E1 (refer to FIG. 6) output from the control substrate 3. The control substrate 3 is formed by, for example, a computer including a CPU, a ROM, and a RAM. Hereinafter, in a case where the power semiconductor elements 10A to 10F are described without being distinguished from each other, each of the power semiconductor elements 10A to 10F will be simply referred to as "power semiconductor element 10".

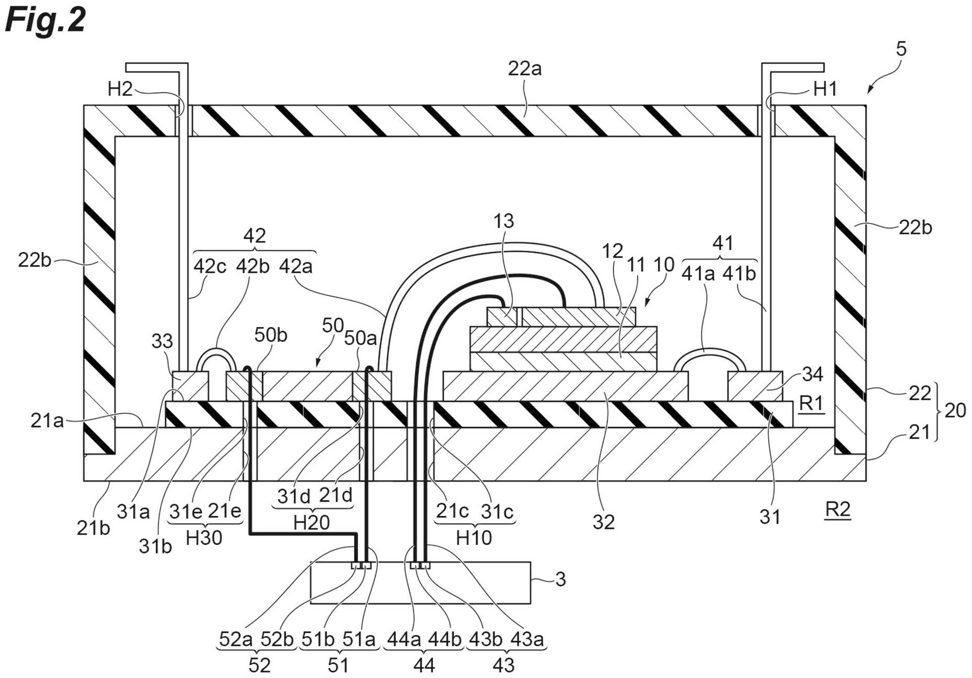

As shown in FIG. 2, the power semiconductor element 10 is accommodated inside a casing 20. The power semiconductor element 10 and the casing 20 form a power semiconductor module 5. In this embodiment, a case where all of the six power semiconductor elements 10A to 10F are accommodated in one casing 20 is exemplified. However, for example, an aspect in which one power semiconductor element is accommodated in each of six casings (that is, an aspect in which one power semiconductor element is accommodated in one casing), an aspect in which two power semiconductor elements are accommodated in each of three casings (that is, an aspect in which two power semiconductor elements are accommodated in one casing), or other aspects may be employed.

In addition, the power semiconductor module 5 is provided with a shunt resistor (sensor element) 50 for electric current measurement. The shunt resistor 50 is accommodated inside the casing 20. The shunt resistor 50 is used as an electric current sensor that detects an electric current output from the power conversion device 1. The shunt resistor 50 is electrically connected in series to a portion in the middle of a second power line portion 42 that is connected to a source electrode 12 of the power semiconductor element 10. The shunt resistor 50 is provided with respect to the second power line portion 42 of a predetermined power semiconductor element 10 so that an electric current output from the power conversion device 1 can be detected.

As shown in FIG. 2, the casing 20 includes a heat dissipation plate 21 on which the power semiconductor element 10 and the shunt resistor 50 are mounted, and a cover 22 that covers the power semiconductor element 10 and the shunt resistor 50. The heat dissipation plate 21 is a plate-shaped member made of a material having thermal conductivity capable of dissipating heat from the power semiconductor element 10 and the shunt resistor 50. The material having thermal conductivity which can dissipate heat from the power semiconductor element 10 and the shunt resistor 50 may be a material having a low thermal resistance in a certain degree capable of thermally transferring heat of the power semiconductor element 10 and the shunt resistor 50 to other components. The heat dissipation plate 21 is, for example, a metal plate made of a metal material such as copper.

This kind of metal material has conductivity (electrical conductivity) capable of shielding a radiation noise. Accordingly, the heat dissipation plate 21 also has a function as a shield plate that shields the radiation noise. The radiation noise is an electromagnetic noise in which an electric field and a magnetic field alternately propagate through a space, and is generated, for example, according to a switching operation of the power semiconductor element 10. Description of "the heat dissipation plate 21 can shield the radiation noise" represents that the heat dissipation plate 21 has a function capable of blocking or suppressing passage of the radiation noise through the heat dissipation plate 21. In this way, the heat dissipation plate 21 has both thermal conductivity capable of dissipating heat from the power semiconductor element 10 and the shunt resistor 50, and electrical conductivity capable of shielding the radiation noise. In this way, the entirety of the heat dissipation plate 21 is configured as a shield layer capable of shielding the radiation noise. However, it is not necessary that the entirety of the heat dissipation plate 21 is configured as the shield layer. The heat dissipation plate 21 may have a configuration in which the shield layer is partially included. The shield layer may be configured as a thin plate made of a material that shields the radiation noise, a mesh, or other known shield structures. For example, the heat dissipation plate 21 may have a configuration in which a metal layer is laminated (plated) as a shield layer on an insulating layer having an electrical insulation property. That is, the heat dissipation plate 21 may include the insulating layer and the metal layer (shield layer) laminated on the insulating layer. It should be noted that examples of a material capable of shielding the radiation noise also include a material having magnetism in addition to the material having electrical conductivity. Accordingly, the heat dissipation plate 21 may be made of a material having magnetism instead of electrical conductivity, or a material having both the electrical conductivity and the magnetism. Even in this configuration, the heat dissipation plate 21 can shield the radiation noise.

The heat dissipation plate 21 has a front surface 21a on which the power semiconductor element 10 and the shunt resistor 50 are mounted, a rear surface 21b on a side opposite to the front surface 21a, and a through-hole 21c that passes through from the front surface 21a to the rear surface 21b. The front surface 21a and the rear surface 21b may be, for example, planes parallel to each other. Description of "the power semiconductor element 10 is mounted on the front surface 21a" also includes a case where the power semiconductor element 10 is indirectly fixed to the front surface 21a through another member in addition to a case where the power semiconductor element 10 is directly fixed to the front surface 21a. In this embodiment, the power semiconductor element 10 is indirectly fixed to the front surface 21a through an insulating layer 31 and a conductive layer 32. Description of "the shunt resistor 50 is mounted on the front surface 21a" also includes a case where the shunt resistor 50 is indirectly fixed to the front surface 21a through another member in addition to a case where the shunt resistor 50 is directly fixed to the front surface 21a. In this embodiment, the shunt resistor 50 is indirectly fixed to the front surface 21a through the insulating layer 31. In the following description, a direction facing the rear surface 21b from the front surface 21a is referred to as "downward", and a direction facing the front surface 21a from the rear surface 21b is referred to as "upward". In addition, a view when the front surface 21a of the heat dissipation plate 21 is viewed from an upward side is referred to as "plan view".

The insulating layer 31 is, for example, a flat plate-shaped ceramic layer having high thermal conductivity. The insulating layer 31 has a rear surface 31b facing the front surface 21a, and a front surface 31a on a side opposite to the rear surface 21b. The conductive layer 32 is, for example, a flat plate-shaped copper plate, and is disposed on the front surface 31a of the insulating layer 31. A conductive layer 33 and a conductive layer 34 are disposed on both sides of the shunt resistor 50 and the conductive layer 32 on the front surface 31a. Each of the conductive layer 33 and the conductive layer 34 may be, for example, a flat plate-shaped copper plate. The conductive layer 33 and the conductive layer 34 are separated from the conductive layer 32 and are electrically insulated from the conductive layer 32. The conductive layer 34 may be integrated with the conductive layer 32 without being separated from the conductive layer 32. In this case, a wire 41a for connecting the conductive layer 32 and the conductive layer 34 can be omitted.

Through-holes 21c and 31c, through-holes 21d and 31d, and through-holes 21e and 31e are formed in the heat dissipation plate 21 and the insulating layer 31, respectively. For example, the through-holes 31c, 31d, and 31e pass through the insulating layer 31 from the front surface 31a exposed between the conductive layer 32 and the conductive layer 33 to the rear surface 31b. The through-holes 21c, 21d, and 21e pass through the heat dissipation plate 21 from the front surface 21a to the rear surface 21b at positions communicating with the through-holes 31c, 31d, and 31e up and down, respectively. The through-holes 21c and 31c have a size allowing a first control line portion 43 and a second control line portion 44 described later to be collectively inserted therethrough. In the present disclosure, since the through-holes 21c and 31c communicate with each other to form a single through-hole, the through-holes 21c and 31c are collectively referred to as "through-hole H10". Similarly, the through-holes 21d and 31d are collectively referred to as "first through-hole H20", and the through-holes 21e and 31e are collectively referred to as "second through-hole H30".

The power semiconductor element 10 includes a drain electrode 11 (first electrode), a source electrode 12 (second electrode), and a gate electrode 13 (control electrode) which are electrically insulated from each other. For example, the source electrode 12 and the gate electrode 13 are located on a side opposite to the drain electrode 11 in the power semiconductor element 10. An arrangement relationship of the source electrode 12, the gate electrode 13, and the drain electrode 11 is not limited to this configuration, and can be appropriately changed. In the power semiconductor element 10 of this embodiment, the drain electrode 11 is disposed on the conductive layer 32 to face the front surface 21a of the heat dissipation plate 21. The configuration in which the drain electrode 11 faces the front surface 21a also includes a case where the drain electrode 11 faces the front surface 21a through another member in addition to a case where the drain electrode 11 directly faces the front surface 21a. In this embodiment, the drain electrode 11 faces the front surface 21a through the conductive layer 32 and the insulating layer 31.

The gate electrode 13 and the source electrode 12 are located on a side opposite to the front surface 21a of the heat dissipation plate 21 with the drain electrode 11 interposed therebetween. Accordingly, in this embodiment, the power semiconductor element 10 is disposed on the conductive layer 32 so that the gate electrode 13 and the source electrode 12 face upward. The gate electrode 13 and the source electrode 12 are electrically connected to the control substrate 3, and the control signal E1 output from the control substrate 3 is input thereto. The control signal E1 is a signal indicating a gate voltage (or a gate current) for controlling switching between conduction and insulation between the drain electrode 11 and the source electrode 12. The gate voltage indicates a difference of a potential of the gate electrode 13 with a potential of the source electrode 12 set as a reference.

The cover 22 is disposed on the front surface 21a of the heat dissipation plate 21 to cover the power semiconductor element 10 and the shunt resistor 50. For example, the cover 22 is used to protect the power semiconductor element 10 and the like from external moisture, dirt, and the like. The cover 22 is made of, for example, a resin material having electrical insulating property. The cover 22 includes a top plate 22a and a side plate 22b (side wall portion). The top plate 22a is a plate member that faces up and down the front surface 21a of the heat dissipation plate 21 through the power semiconductor element 10 and the shunt resistor 50. The side plate 22b is a frame-shaped plate member that connects the top plate 22a and the front surface 21a up and down, and surrounds the power semiconductor element 10 and the shunt resistor 50. The cover 22 is attached to the front surface 21a of the heat dissipation plate 21 to cover the power semiconductor element 10 and the shunt resistor 50.

The power semiconductor module 5 further includes a first power line portion 41 that is electrically connected to the drain electrode 11, a second power line portion 42 that is electrically connected to the source electrode 12, a first control line portion 43 that is electrically connected to the gate electrode 13, and a second control line portion 44 that is electrically connected to the source electrode 12. In this specification, a configuration in which a certain element is "electrically connected" to another element represents that two elements are connected in a state in which transmission of a signal and supply of electric power are possible between the two elements. Accordingly, description of "electrically connected" includes both a case where the two elements are directly connected by a wire, and a case where the two elements are indirectly connected through another electrical element.

The first power line portion 41 and the second power line portion 42 form a main circuit for supplying electric power from the drain electrode 11 to the source electrode 12. Each of the first power line portion 41 and the second power line portion 42 is formed by one or a plurality of electric conductors capable of transmitting electric power from the drain electrode 11 to the source electrode 12. The electric conductors forming the first power line portion 41 and the second power line portion 42 may be, for example, conductors such as a wire, a conductive wire, an electric wire, a cable, or a lead terminal. The first power line portion 41 and the second power line portion 42 extend upward from the drain electrode 11 and the source electrode 12 toward the top plate 22a, and are drawn out from a region covered by the cover 22 in a region R1 to a region on an outer side of the region through the top plate 22a. In other words, the first power line portion 41 and the second power line portion 42 are drawn out from the inside of the casing 20 to the outside through the upper top plate 22a. More specifically, the first power line portion 41 and the second power line portion 42 are drawn out to an upward side of the top plate 22a through the through-holes H1 and H2 formed in the top plate 22a, respectively.

The first power line portion 41 includes, for example, a wire 41a and a lead terminal 41b. The wire 41a connects the drain electrode 11 and the conductive layer 34. A base end of the lead terminal 41b is connected to the conductive layer 34. A tip end of the lead terminal 41b is drawn out to the outside of the cover 22 through the through-hole H1 in the top plate 22a. The lead terminal 41b is electrically connected to the drain electrode 11 through the conductive layer 34 and the wire 41a. Therefore, electric power applied to the lead terminal 41b is input to the drain electrode 11 through the conductive layer 34 and the wire 41a.

The shunt resistor 50 is electrically connected in series to a middle portion of the second power line portion 42. Here, the shunt resistor 50 includes a first terminal 50a and a second terminal 50b. The first terminal 50a and the second terminal 50b are electrically connected to each other by an electric conductor having a predetermined resistance value. The second power line portion 42 includes, for example, a wire 42a, a wire 42b, and a lead terminal 42c. The wire 42a connects the source electrode 12 and the first terminal 50a of the shunt resistor 50. The wire 42b connects the second terminal 50b of the shunt resistor 50 and the conductive layer 33. A base end of the lead terminal 42c is connected to the conductive layer 33. A tip end of the lead terminal 42c is drawn out to the outside of the cover 22 through the through-hole H2 of the top plate 22a. The lead terminal 42c is electrically connected to the source electrode 12 through the conductive layer 33, the wire 42b, the shunt resistor 50, and the wire 42a. Therefore, electric power output from the source electrode 12 is transmitted to the lead terminal 42c through the wire 42a, the shunt resistor 50, the wire 42b, and the conductive layer 33.

The first control line portion 43 and the second control line portion 44 form a control circuit for applying the control signal E1 to the gate electrode 13. Each of the first control line portion 43 and the second control line portion 44 is formed by one or a plurality of electric conductors capable of transmitting a gate voltage indicated by the control signal E1 to the gate electrode 13. The electric conductors forming the first control line portion 43 and the second control line portion 44 may be, for example, conductors such as a wire, a conductive wire, an electric wire, a cable, or a lead terminal. The first control line portion 43 and the second control line portion 44 are drawn out from inside the casing 20 to the outside of the casing 20 through the through-hole H10 of the heat dissipation plate 21 on a downward side.

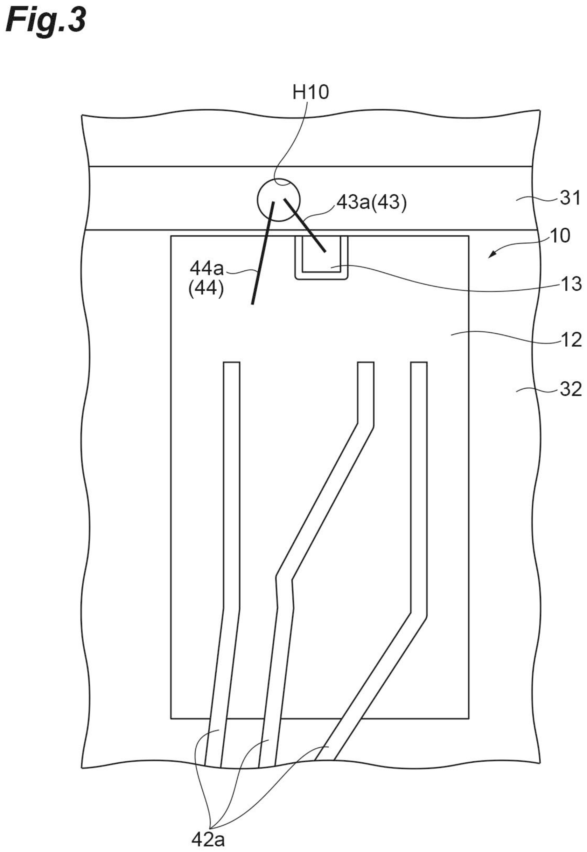

The through-hole H10 through which the first control line portion 43 and the second control line portion 44 pass is formed at a position that does not overlap the gate electrode 13 and the source electrode 12 in a plan view as shown in FIG. 2 and FIG. 3, and more specifically, at a position spaced apart from the gate electrode 13 and the source electrode 12.

As shown in FIG. 2, the first control line portion 43 includes, for example, a wire 43a and a connection terminal 43b. The wire 43a is connected to the gate electrode 13. The wire 43a extends downward from the gate electrode 13 and is drawn out to a region R2 on the rear surface 21b of the heat dissipation plate 21 through the through-hole H10. In other words, the wire 43a is drawn out from inside the casing 20 to the outside of the casing 20 through the heat dissipation plate 21. The wire 43a drawn out to a downward side of the heat dissipation plate 21 is connected to the control substrate 3 through the connection terminal 43b.

The second control line portion 44 includes, for example, a wire 44a and a connection terminal 44b. The wire 44a is connected to the source electrode 12 at a site different from a connection site of the wire 42a to the source electrode 12 (refer to FIG. 3). The wire 44a extends downward from the source electrode 12 and is drawn out to the region R2 on the rear surface 21b of the heat dissipation plate 21 through the through-hole H10 in combination with the wire 43a of the first control line portion 43. That is, the wire 44a is drawn out from the inside of the casing 20 to the outside of the casing 20 through the heat dissipation plate 21 in combination with the wire 43a. The wire 44a drawn out to a downward side of the heat dissipation plate 21 is connected to the control substrate 3 through the connection terminal 44b. A reference potential of the control signal E1 is applied to the second control line portion 44. The reference potential represents an arbitrarily determined reference potential, and is not limited to 0 V. The gate voltage indicated by the control signal E1 is represented as a difference between a potential of the first control line portion 43 and the reference potential of the second control line portion 44.

When the control signal E1 is input to the gate electrode 13 by the first control line portion 43 and the second control line portion 44, timing of turning on or off the power semiconductor element 10 is controlled. When the gate voltage indicated by the control signal E1 is equal to or higher than a threshold voltage (for example, 5 V), the power semiconductor element 10 is turned on, and the drain electrode 11 and the source electrode 12 are in a conduction state. At this time, high electric power, for example, several thousand A or several thousand V is applied to the drain electrode 11 and the source electrode 12 through the first power line portion 41 and the second power line portion 42. On the other hand, when the gate voltage is smaller than the threshold voltage, the power semiconductor element 10 is turned off, and the drain electrode 11 and the source electrode 12 are in an insulated state. In this way, conduction and insulation (non-conduction) between the drain electrode 11 and the source electrode 12 are switched in response to the control signal E1, and thus a mode of electric power is switched by the power conversion device 1.

The power semiconductor module 5 further includes a first sensor line portion 51 and a second sensor line portion 52 electrically connected to the shunt resistor 50. Each of the first sensor line portion 51 and the second sensor line portion 52 is formed by an electric conductor capable of transmitting a detection signal of the shunt resistor 50 to the control board 3. **In** this embodiment, the detection signal of the shunt resistor 50 is a voltage between the first terminal 50a and the second terminal 50b of the shunt resistor 50. The control substrate 3 can switch, for example, conduction and insulation between the drain electrode 11 and the source electrode 12 based on the detection signal of the shunt resistor 50. The electric conductors forming the first sensor line portion 51 and the second sensor line portion 52 may be, for example, conductors such as a wire, a conductive wire, an electric wire, a cable, or a lead terminal. The first sensor line portion 51 and the second sensor line portion 52 are drawn out from inside the casing 20 to the outside of the casing 20 through the first through-hole H20 and the second through-hole H30 in the heat dissipation plate 21 on a downward side, respectively.

The first sensor line portion 51 includes, for example, a wire 51a and a connection terminal 51b. The wire 51a is connected to the first terminal 50a of the shunt resistor 50. The wire 51a extends downward from the first terminal 50a and is drawn out to the region R2 on the rear surface 21b of the heat dissipation plate 21 through the first through-hole H20. The wire 51a drawn out to a downward side of the heat dissipation plate 21 is connected to the control substrate 3 through the connection terminal 51b. The second sensor line portion 52 includes, for example, a wire 52a and a connection terminal 52b. The wire 52a is connected to the second terminal 50b of the shunt resistor 50. The wire 52a extends downward from the second terminal 50b and is drawn out to the region R2 on the rear surface 21b of the heat dissipation plate 21 through the second through-hole H30. The wire 52a drawn out to a downward side of the heat dissipation plate 21 is connected to the control substrate 3 through the connection terminal 52b.

In this embodiment, the first power line portion 41 and the second power line portion 42 are drawn out to the outside of the casing 20 through the cover 22 on an upward side. On the other hand, the first sensor line portion 51 and the second sensor line portion 52 are drawn out to the outside of the casing 20 through the heat dissipation plate 21 on a downward side. In other words, among the first power line portion 41, the second power line portion 42, the first sensor line portion 51, and the second sensor line portion 52, only the first sensor line portion 51 and the second sensor line portion 52 are drawn out to the region R2 on the rear surface 21b of the heat dissipation plate 21 through the first through-hole H20 and the second through-hole H30, respectively. As a result, the region R1 where the first power line portion 41 and the second power line portion 42 are drawn out and the region R2 where the first sensor line portion 51 and the second sensor line portion 52 are drawn out are separated from each other by the heat dissipation plate 21. The region R1 may be one of a pair of regions located on both sides of the heat dissipation plate 21 which faces the front surface 21a. The region R2 may be a region of the pair of regions which faces the rear surface 21b.

Therefore, the first sensor line portion 51 and the second sensor line portion 52 are drawn out to a side opposite to the first power line portion 41 and the second power line portion 42 with the heat dissipation plate 21 interposed therebetween. As a result, a portion including at least a tip end of each of the first sensor line portion 51 and the second sensor line portion 52 is disposed in the region R2 on the rear surface 21b, and a portion including at least a tip end of each of the first power line portion 41 and the second power line portion 42 is disposed in the region R1. The tip end of the first power line portion 41 represents one end opposite to the base end of the first power line portion 41 connected to the drain electrode 11. The tip end of the second power line portion 42 represents one end opposite to the base end of the second power line portion 42 connected to the source electrode 12. The tip end of the first sensor line portion 51 represents one end opposite to the base end of the first sensor line portion 51 connected to the first terminal 50a. The tip end of the second sensor line portion 52 represents one end opposite to the base end of the second sensor line portion 52 connected to the second terminal 50b.

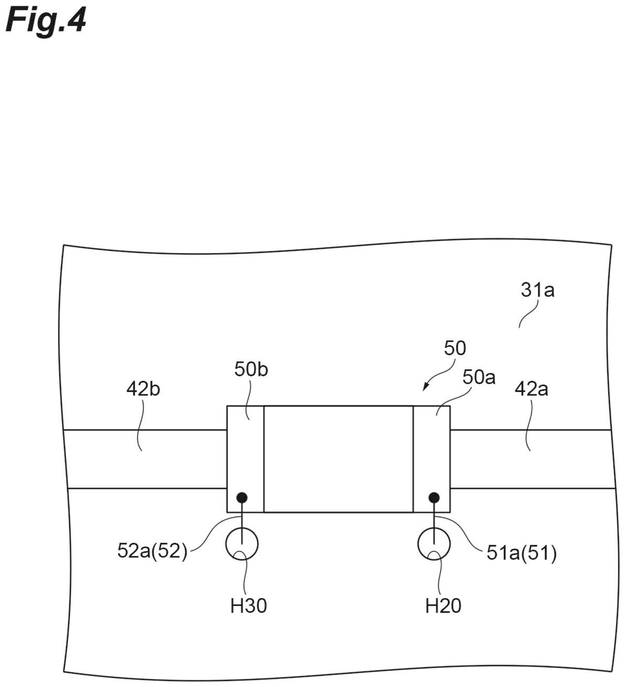

As shown in FIG. 2 and FIG. 4, the first through-hole H20 through which the first sensor line portion 51 passes is formed at a position that does not overlap the first power line portion 41 and the second power line portion 42 in a plan view, more specifically, at a position spaced apart from the first power line portion 41 and the second power line portion 42. The second through-hole H30 through which the second sensor line portion 52 passes is formed at a position that does not overlap the first power line portion 41 and the second power line portion 42 in a plan view, more specifically, at a position spaced apart from the first power line portion 41 and the second power line portion 42.

In addition, the first through-hole H20 is provided at a position closer to the first terminal 50a as compared with the second through-hole H30 in a plan view. The second through-hole H30 is provided at a position closer to the second terminal 50b as compared with the first through-hole H20 in a plan view.

Hereinafter, operational effects of the power semiconductor module 5 and the power conversion device 1 of this embodiment will be described in combination with problems of a comparative example.

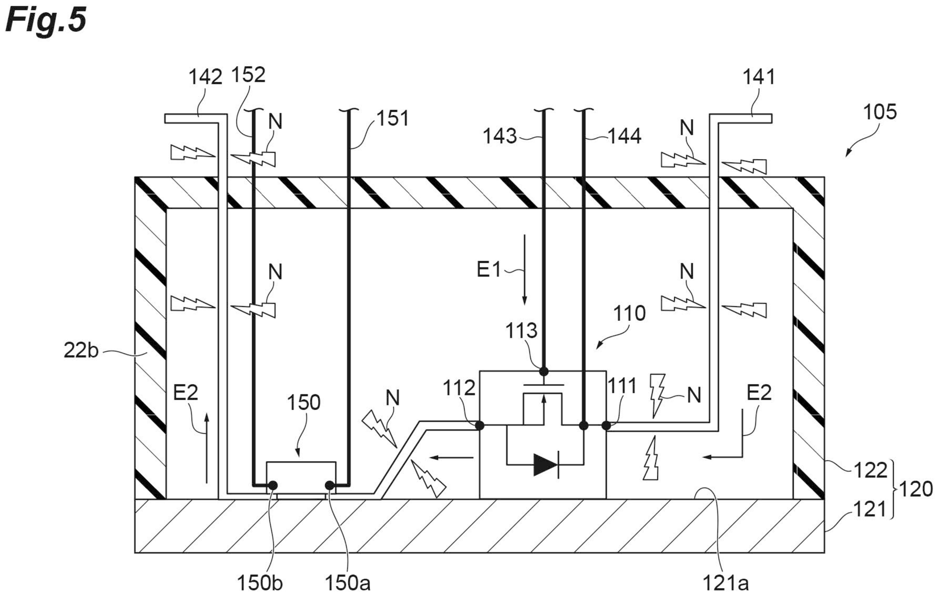

In FIG. 5, a power semiconductor element 110 is shown simply as a circuit diagram. FIG. 5 is a cross-sectional view illustrating a power semiconductor module 105 of a comparative example in a simplified manner. The power semiconductor module 105 includes a casing 120 including a heat dissipation plate 121 and a cover 122, a power semiconductor element 110 disposed on a front surface 121a of the heat dissipation plate 121, a first power line portion 141 connected to a drain electrode 111, a second power line portion 142 connected to a source electrode 112, a first control line portion 143 connected to a gate electrode 113, and a second control line portion 144 connected to a source electrode 112. In the power semiconductor module 105, a control signal E1 is input to the gate electrode 113 through the first control line portion 143 and the second control line portion 144. Conduction and insulation between the drain electrode 111 and the source electrode 112 are alternately switched in response to the control signal E1. The first power line portion 141, the second power line portion 142, the first control line portion 143, and the second control line portion 144 are drawn out in combination to the outside of the casing 120 through an upper cover 122.

In addition, the power semiconductor module 105 further includes a shunt resistor 150 electrically connected in series to a middle portion of the second power line portion 142, a first sensor line portion 151 connected to a first terminal 150a of the shunt resistor 150, and a second sensor line portion 152 connected to a second terminal 150b of the shunt resistor 150. The first sensor line portion 151 and the second sensor line portion 152 are drawn out to the outside of the casing 120 through the cover 122 on an upward side in combination with the first power line portion 141 and the second power line portion 142.

As in the power semiconductor module 105, in a case where the first power line portion 141, the second power line portion 142, the first sensor line portion 151, and the second sensor line portion 152 are drawn out in combination in the same direction, there is a concern that a large radiation noise N radiated from the first power line portion 141 and the second power line portion 142 to which high electric power E2 is applied may easily propagate to the first sensor line portion 151 and the second sensor line portion 152. Since the radiation noise N is an electromagnetic wave, the radiation noise has a property of traveling in a straight line. Therefore, the radiation noise N radiated from the first power line portion 141 and the second power line portion 142 easily propagates to the first sensor line portion 151 and the second sensor line portion 152 drawn upward in combination with the first power line portion 141 and the second power line portion 142. The radiation noise N propagated to the first sensor line portion 151 and the second sensor line portion 152 becomes a noise factor that causes a detection signal of the shunt resistor 150 to fluctuate.

The high electric power E2, for example, several thousand V or several thousand A is applied to the first power line portion 141 and the second power line portion 142. Therefore, a large radiation noise N tends to be radiated from the first power line portion 141 and the second power line portion 142. On the other hand, as the shunt resistor 150, a shunt resistor having a small resistance value is used from the viewpoint of suppressing the amount of heat generation. A voltage (potential difference) between the first terminal 150a and the second terminal 150b of the shunt resistor 150 is exceedingly small as compared with the electric power E2 applied to the first power line portion 141 and the second power line portion 142. Therefore, when the large radiation noise N radiated from the first power line portion 141 and the second power line portion 142 propagates to the first sensor line portion 151 and the second sensor line portion 152, the detection signal of the shunt resistor 150 is greatly disturbed. As a result, an electric current output from the power semiconductor module 105 cannot be detected accurately by using the shunt resistor 150.

On the other hand, in the power semiconductor module 5 according to this embodiment, as shown in FIG. 6, the first sensor line portion 51 and the second sensor line portion 52 are drawn downward to a side opposite to the first power line portion 41 and the second power line portion 42. It should be noted that FIG. 6 is a cross-sectional view illustrating the power semiconductor module 5 according to this embodiment in a simplified manner, and the power semiconductor element 10 is shown simply as a circuit diagram. As shown in FIG. 6, the first sensor line portion 51 and the second sensor line portion 52 are drawn out to the region R2 on a side opposite to the region R1 from which the first power line portion 41 and the second power line portion 42 are drawn out with the heat dissipation plate 21 as a shield plate for shielding the radiation noise N interposed therebetween. As a result, the large radiation noise N radiated from the first power line portion 41 and the second power line portion 42 is shielded by the heat dissipation plate 21 and does not propagate to the first sensor line portion 51 and the second sensor line portion 52.

Specifically, at the inside of the casing 20, since the radiation noise N radiated from the first power line portion 41 and the second power line portion 42 is blocked by the heat dissipation plate 21, the radiation noise N does not propagate to the first sensor line portion 51 and the second sensor line portion 52 on the rear surface 21b of the heat dissipation plate 21. Furthermore, at the outside of the casing 20, the first sensor line portion 51 and the second sensor line portion 52 are not disposed in a direction in which the radiation noise N radiated from the first power line portion 41 and the second power line portion 42 propagates. Therefore, such radiation noise N also does not propagate to the first sensor line portion 51 and the second sensor line portion 52. In this way, since the first sensor line portion 51 and the second sensor line portion 52 are drawn out to a side opposite to the first power line portion 41 and the second power line portion 42 through the heat dissipation plate 21, and the heat dissipation plate 21 is used as a shield plate, it is possible to suppress the large radiation noise N radiated from the first power line portion 41 and the second power line portion 42 from propagating to the first sensor line portion 51 and the second sensor line portion 52. As a result, the power semiconductor module 5 can suppress the detection signal of the shunt resistor 50 from being affected by the radiation noise N.

As described above, high electric power is applied to the drain electrode 11 and the source electrode 12 in a conduction state. On the other hand, as the shunt resistor 50 for detecting an electric current output from the power semiconductor module 5, a shunt resistor having a small resistance value is used to suppress the amount of heat generation. As a result, a voltage between both ends of the shunt resistor 50 to be measured in order to detect the electric current output from the power semiconductor module 5 is extremely lower as compared with a high voltage applied to the power semiconductor element 10. As an example, the electric power handled by the power semiconductor element 10 is high electric power of several hundred A or several hundred V, whereas the electric power handled by the shunt resistor 50 is approximately 1/1000 times the electric power handled by the power semiconductor element 10. In this way, in the power semiconductor element 10 and the shunt resistor 50, a digit number of a value of handled electric power is significantly different. As described above, since the detection signal of the shunt resistor 50 is weak, the detection signal of the shunt resistor 50 is easily affected by the radiation noise N. In the power semiconductor module 5 according to this embodiment, even when such a shunt resistor 50 is used, the detection signal of the shunt resistor 50 (the voltage value between both ends of the shunt resistor) can be suppressed from being affected by the radiation noise N. According to this, it is possible to measure the electric current output from the power semiconductor module 5 with more accuracy by the shunt resistor 50.

As in this embodiment, the shunt resistor 50 may be mounted on the front surface 21a of the heat dissipation plate 21, and the heat dissipation plate 21 may be capable of dissipating heat from the shunt resistor 50. When electric current flows through the shunt resistor 50, the shunt resistor 50 generates heat. Even in such a case, the power semiconductor module 5 can shield the radiation noise N by using the heat dissipation plate 21 while dissipating heat from the shunt resistor 50 that generates heat.

As in this embodiment, the first through-hole H20 and the second through-hole H30 may be formed at positions that do not overlap the first power line portion 41 and the second power line portion 42 in a plan view of the heat dissipation plate 21. In this case, the power semiconductor module 5 can suppress the radiation noise N radiated from the first power line portion 41 and the second power line portion 42 from propagating to the rear surface 21b of the heat dissipation plate 21 through the first through-hole H20 and the second through-hole H30.

As in this embodiment, the first sensor line portion 51 and the second sensor line portion 52 may be drawn out to a region on the rear surface 21b of the heat dissipation plate 21 through the first through-hole H20 and the second through-hole H30 respectively formed at different positions. In this case, the first through-hole H20 can be formed at a position close to the first terminal 50a of the shunt resistor 50. In addition, the second through-hole H30 can be formed at a position close to the second terminal 50b of the shunt resistor 50. According to this, the first sensor line portion 51 and the second sensor line portion 52 can reach the first through-hole H20 and the second through-hole H30, respectively, in the shortest distance. In this way, since portions of the first sensor line portion 51 and the second sensor line portion 52 which are exposed to the inside of the casing 20 through which the radiation noise N can propagate can be minimized, it is possible to reduce the risk in which the radiation noise N propagates to the first sensor line portion 51 and the second sensor line portion 52 inside of the casing 20.

As in this embodiment, the first power line portion 41 and the second power line portion 42 may extend from the source electrode 12 and the gate electrode 13 toward the top plate 22a of the cover 22, and may be drawn out through the top plate 22a to the outside of the region covered with the cover 22. In such a configuration, since the first sensor line portion 51 and the second sensor line portion 52 can be drawn out to a side opposite the first power line portion 41 and the second power line portion 42, the propagation of the radiation noise N from the first power line portion 41 and the second power line portion 42 to the first sensor line portion 51 and the second sensor line portion 52 can be more effectively suppressed.

Hereinbefore, the embodiment of the present disclosure has been described, but the present disclosure is not limited to the embodiment described above.

### <Modification Example 1>

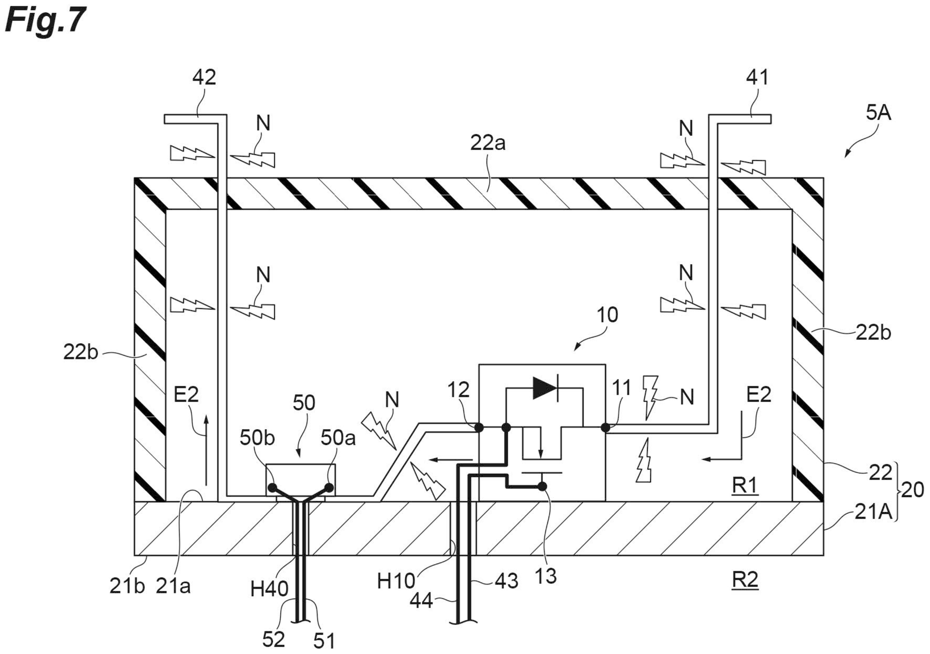

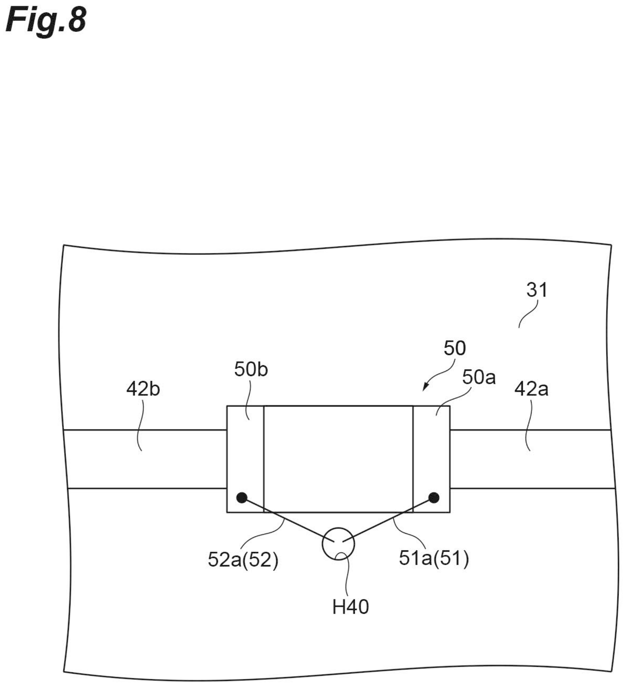

FIG. 7 is a cross-sectional view illustrating a power semiconductor module 5A of Modification Example 1. In the above-described embodiment, the first through-hole H20 and the second through-hole H30 are formed in the heat dissipation plate 21, but in Modification Example 1, a through-hole H40 is formed in a heat dissipation plate 21A. As shown in FIG. 7 and FIG. 8, the through-hole H40 is formed at a position that does not overlap the first power line portion 41 and the second power line portion 42 in a plan view, more specifically, at a position spaced apart from the first power line portion 41 and the second power line portion 42. The through-hole H40 may be provided at a position close to the shunt resistor 50 in a plan view. The first sensor line portion 51 and the second sensor line portion 52 are drawn out to the region R2 on the rear surface 21b of the heat dissipation plate 21A through the single through-hole H40.

In this way, in the power semiconductor module 5A, since the first sensor line portion 51 and the second sensor line portion 52 collectively pass through the single through-hole H40, a distance between the first sensor line portion 51 and the second sensor line portion 52 becomes short, and according to this, an area of a loop formed by the first sensor line portion 51 and the second sensor line portion 52 is reduced. In this way, when the area of the loop is reduced, an electromotive force generated when the electromagnetic wave (radiation noise N) interlinks the loop can be reduced. According to this, the power semiconductor module 5A can reduce a risk in which a large conduction noise is generated in the first sensor line portion 51 and the second sensor line portion 52.

### <Modification Example 2>

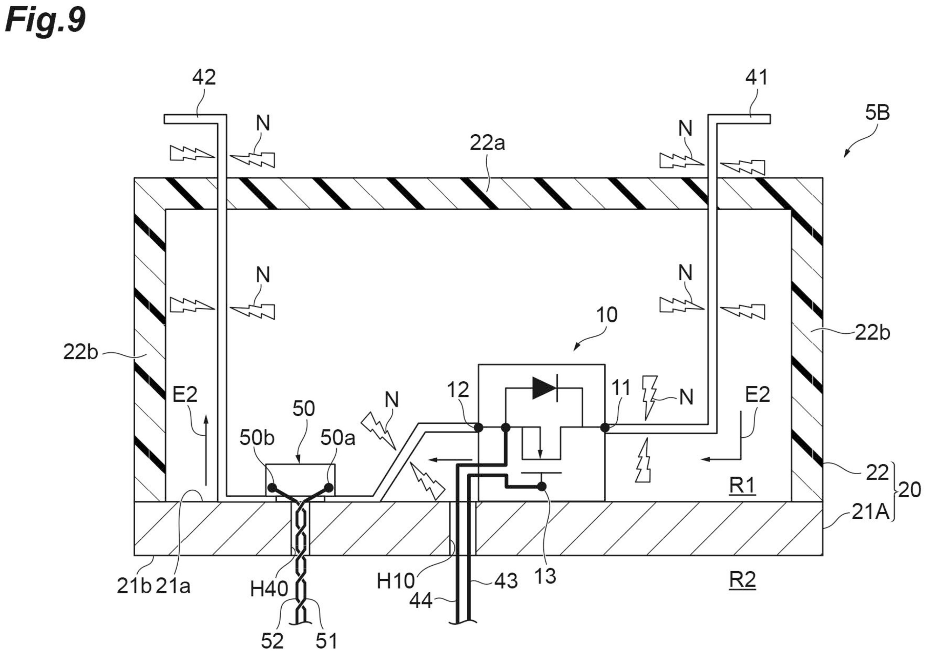

FIG. 9 is a cross-sectional view illustrating a power semiconductor module 5B of Modification Example 2 in a simplified manner. As shown in FIG. 9, in the power semiconductor module 5B, the first sensor line portion 51 and the second sensor line portion 52 are twisted with each other. The first sensor line portion 51 and the second sensor line portion 52 are drawn out to the region R2 on the rear surface 21b of the heat dissipation plate 21A from the inside of the casing 20 through the through-hole H40 in a state of being twisted with each other.

In this way, the first sensor line portion 51 and the second sensor line portion 52 are twisted with each other. In this case, even though the radiation noise N radiated from the first power line portion 41 and the second power line portion 42 propagates to the first sensor line portion 51 and the second sensor line portion 52, a conduction noise generated in the first sensor line portion 51 and the second sensor line portion 52 and a conduction noise generated in a twisted portion operate to cancel each other. Therefore, the power semiconductor module 5B can reduce a risk in which a large conduction noise is generated in the first sensor line portion 51 and the second sensor line portion 52.

### <Modification Example 3>

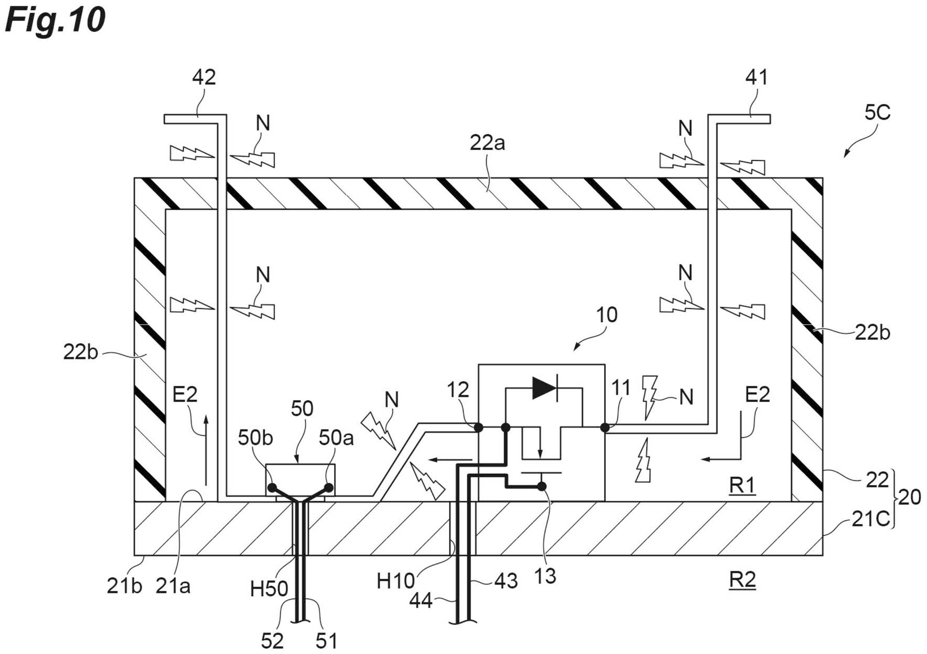

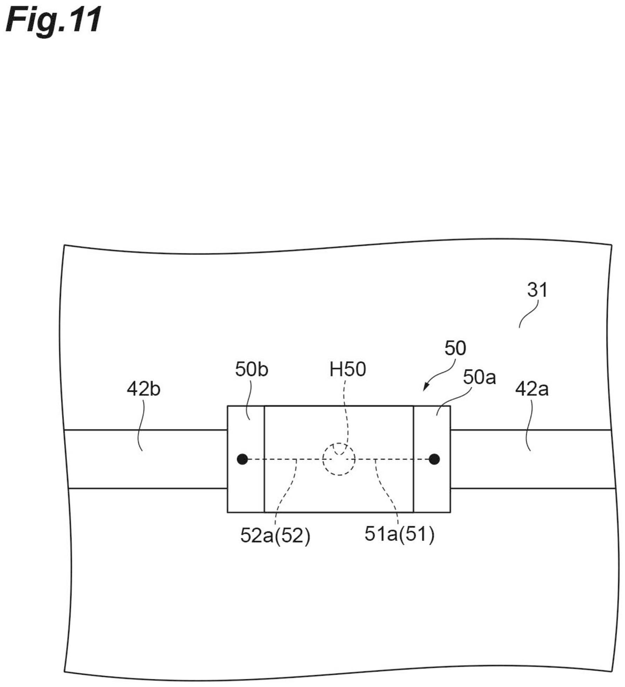

FIG. 10 is a cross-sectional view illustrating a power semiconductor module 5C of Modification Example 3 in a simplified manner. As shown in FIG. 10 and FIG. 11, in the power semiconductor module 5C, a through-hole H50 is formed at a position that overlaps the shunt resistor 50 in a plan view. In addition, the through-hole H50 is formed at a position that does not overlap the first power line portion 41 and the second power line portion 42 in a plan view. The first sensor line portion 51 is connected to the first terminal 50a on a lower surface (a surface facing the front surface 21a of the heat dissipation plate 21C) of the shunt resistor 50. The second sensor line portion 52 is connected to the second terminal 50b on the lower surface of the shunt resistor 50. The first sensor line portion 51 and the second sensor line portion 52 are drawn out from the inside of the casing 20 to the region R2 on the rear surface 21b of the heat dissipation plate 21C through the through-hole H50. **In** the power semiconductor module 5C, when the shunt resistor 50 is viewed from an upward side, the first sensor line portion 51, the second sensor line portion 52, and the through-hole H50 are covered with the shunt resistor 50.

In this case, in the power semiconductor module 5C, the first sensor line portion 51 and the second sensor line portion 52 can reach the through-hole H50 from the lower surface of the shunt resistor 50 in the shortest distance. According to this, since portions of the first sensor line portion 51 and the second sensor line portion 52 which are exposed to the inside of the casing 20 through which the radiation noise N propagates can be minimized, it is possible to reduce a risk in which the radiation noise N propagates to the first sensor line portion 51 and the second sensor line portion 52 at the inside of the casing 20. **In** addition, since the first sensor line portion 51 and the second sensor line portion 52 are covered with the shunt resistor 50, it is possible to further reduce the risk in which the radiation noise N propagates to the first sensor line portion 51 and the second sensor line portion 52.

### <Modification Example 4>

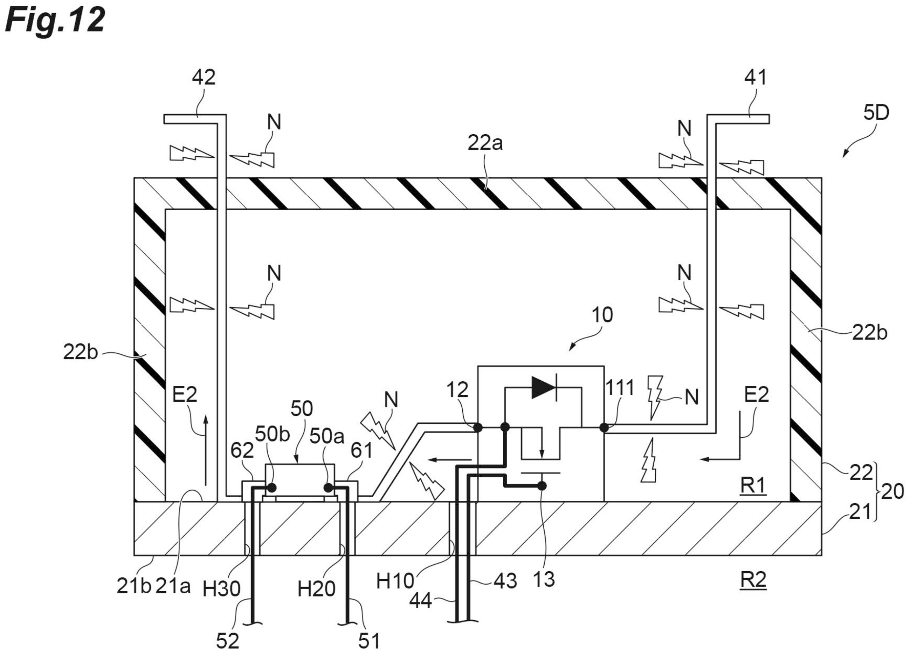

FIG. 12 is a cross-sectional view illustrating a power semiconductor module 5D of Modification Example 4 in a simplified manner. As shown in FIG. 12, the power semiconductor module 5D of Modification Example 4 includes a first magnetic shield 61 (magnetic shield) and a second magnetic shield 62 (magnetic shield) that respectively surround the first sensor line portion 51 and the second sensor line portion 52 at the inside of the casing 20. The first magnetic shield 61 is a cylindrical member that extends between an end portion of the first sensor line portion 51 on a side connected to the shunt resistor 50 and an opening of the first through-hole H20 in the front surface 21a of the heat dissipation plate 21. The first magnetic shield 61 is disposed to surround the first sensor line portion 51 inside the casing 20. The first sensor line portion 51 is drawn out from the first through-hole H20 to the region R2 on the rear surface 21b of the heat dissipation plate 21 through the inside of the first magnetic shield 61. The second magnetic shield 62 is a cylindrical member that extends between an end portion of the second sensor line portion 52 on a side connected to the shunt resistor 50 and an opening of the second through-hole H30 in the front surface 21a of the heat dissipation plate 21. The second magnetic shield 62 is disposed to surround the second sensor line portion 52 inside the casing 20. The second sensor line portion 52 passes through the inside of the second magnetic shield 62 and is drawn out from the second through-hole H30 to the region R2 on the rear surface 21b of the heat dissipation plate 21.

Each of the first magnetic shield 61 and the second magnetic shield 62 includes a shield layer capable of shielding the radiation noise N radiated from the first power line portion 41 and the second power line portion 42. The entirety of each of the first magnetic shield 61 and the second magnetic shield 62 may be formed by the shield layer, or the shield layer may be provided at a part. Examples of the shield layer capable of shielding the radiation noise N also include a material having magnetism in addition to a material having electrical conductivity. Accordingly, the shield layer that forms the first magnetic shield 61 and the second magnetic shield 62 may be made of a material having magnetism instead of electrical conductivity, or may be made of a material having both the electrical conductivity and the magnetism. The first magnetic shield 61 and the second magnetic shield 62 may be, for example, electrically conductive pipes formed by an aluminum pipe, a copper pipe, or the like. The first magnetic shield 61 and the second magnetic shield 62 may be formed by, for example, an electrically conductive thin film such as aluminum foil or copper foil, or may be an electrically conductive cylindrical mesh made of woven aluminum wires or copper wires.

According to this configuration, the radiation noise N radiated from the first power line portion 41 and the second power line portion 42 is shielded by the first magnetic shield 61 and the second magnetic shield 62. Therefore, the power semiconductor module 5D can suppress propagation of the radiation noise N to the first sensor line portion 51 inside the first magnetic shield 61 and the second sensor line portion 52 inside the second magnetic shield 62.

It should be noted that in each of the modification examples, a magnetic shield that surrounds the first sensor line portion 51 and the second sensor line portion 52, or a magnetic shield that collectively surrounds the first sensor line portion 51 and the second sensor line portion 52 may be provided inside the casing 20.

### <Modification Example 5>

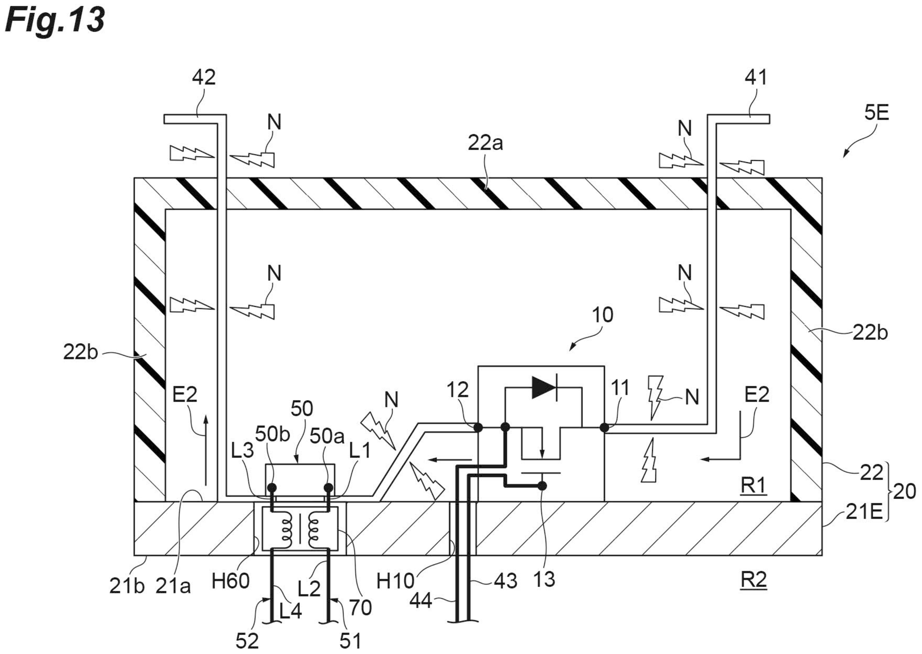

FIG. 13 is a cross-sectional view illustrating a power semiconductor module 5E of Modification Example 5. As shown in FIG. 13, in the power semiconductor module 5E, the first sensor line portion 51 and the second sensor line portion 52 include a common mode filter 70 capable of removing a common mode component of the conduction noise conducting through the first sensor line portion 51 and the second sensor line portion 52. The conduction noise is an electromagnetic noise that propagates through a conductor that is used for input/output of electric power, and is generated by a switching operation of the power semiconductor element 10.

The common mode filter 70 is provided, for example, inside of a through-hole H60 provided in a heat dissipation plate 21E. That is, the common mode filter 70 is disposed between a front surface 21a and a rear surface of the heat dissipation plate 21E, and is embedded inside the heat dissipation plate 21E. The first sensor line portion 51 includes a line L1 that connects the first terminal 50a and the common mode filter 70 at the inside of the casing 20, the common mode filter 70 inside the heat dissipation plate 21E, and a line L2 that connects the common mode filter 70 and the connection terminal 51b (refer to FIG. 2) at the outside of the casing 20. The second sensor line portion 52 includes a line L3 that connects the second terminal 50b and the common mode filter 70 at the inside of the casing 20, the common mode filter 70 inside the heat dissipation plate 21E, and a line L4 that connects the common mode filter 70 and the connection terminal 52b (refer to FIG. 2) at the outside of the casing 20.

In the power semiconductor module 5E, since the common mode component of the conduction noise that may occur in the first sensor line portion 51 and the second sensor line portion 52 can be removed, it is possible to suppress occurrence of a fluctuation of a detection signal of the shunt resistor 50 which is caused by the common mode component. In addition, since the common mode filter 70 is disposed inside the through-hole H60, it is possible to suppress propagation of the radiation noise N from the first power line portion 41 and the second power line portion 42 to the first sensor line portion 51 and the second sensor line portion 52 through the common mode filter 70.

It should be noted that it is not necessary for the common mode filter 70 to be disposed inside the through-hole H60. For example, the common mode filter 70 may be disposed on the front surface 21a or may be disposed on the rear surface 21b. In a case where the common mode filter 70 is disposed on the front surface 21a, the first sensor line portion 51 and the second sensor line portion 52 between the shunt resistor 50 and the common mode filter 70 may be twisted with each other. In a case where the common mode filter 70 is disposed on the front surface 21a, the first sensor line portion 51 and the second sensor line portion 52 between the shunt resistor 50 and the common mode filter 70, and the common mode filter 70 on the front surface 21a may be surrounded by an electromagnetic shield. The power semiconductor module 5E may include a ferrite core instead of the common mode filter 70. In this case, the first sensor line portion 51 and the second sensor line portion 52 may linearly pass through the ferrite core having a ring shape. Alternatively, the first sensor line portion 51 and the second sensor line portion 52 may be wound around the ring-shaped ferrite core, or may form a common mode choke coil.

### <Modification Example 6>

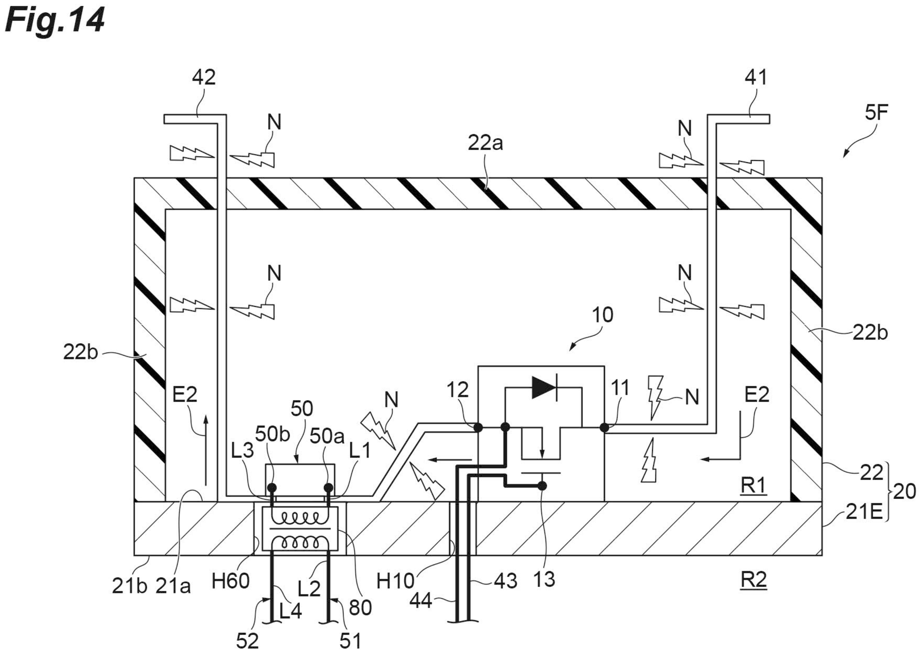

FIG. 14 is a cross-sectional view of a power semiconductor module 5F of Modification Example 6. As shown in FIG. 14, in the power semiconductor module 5F, the first sensor line portion 51 and the second sensor line portion 52 include a transformer 80 capable of removing a common mode component of the conduction noise conducting through the first sensor line portion 51 and the second sensor line portion 52. The transformer 80 is disposed, for example, inside the through-hole H60 provided in the heat dissipation plate 21E. That is, the transformer 80 is disposed between a front surface 21a and a rear surface 21b of the heat dissipation plate 21E, and is embedded inside the heat dissipation plate 21E. The first sensor line portion 51 includes a line L1 that connects the first terminal 50a and the transformer 80 at the inside of the casing 20, the transformer 80 inside the heat dissipation plate 21E, and a line L2 that connects the transformer 80 and the connection terminal 51b (refer to FIG. 2) at the outside of the casing 20. The second sensor line portion 52 includes a line L3 that connects the second terminal 50b and the transformer 80 at the inside of the casing 20, the transformer 80 inside the heat dissipation plate 21E, and a line L4 that connects the transformer 80 and the connection terminal 52b (refer to FIG. 2) at the outside of the casing 20.

In the power semiconductor module 5F, since the common mode component of the conduction noise that may occur in the first sensor line portion 51 and the second sensor line portion 52 can be removed, it is possible to suppress occurrence of a fluctuation of a detection signal of the shunt resistor 50 which is caused by the common mode component. In addition, since the transformer 80 is disposed inside the through-hole H60, it is possible to suppress propagation of the radiation noise N from the first power line portion 41 and the second power line portion 42 to the first sensor line portion 51 and the second sensor line portion 52 through the transformer 80. Furthermore, when the transformer 80 is disposed inside the heat dissipation plate 21E, a function of electrically insulating the inside and the outside of the casing 20 from each other can be exhibited.

It should be noted that it is not necessary for the transformer 80 to be disposed inside the through-hole H60. For example, the transformer 80 may be disposed on the front surface 21a or may be disposed on the rear surface 21b. In a case where the transformer 80 is disposed on the front surface 21a, the first sensor line portion 51 and the second sensor line portion 52 between the shunt resistor 50 and the transformer 80 may be twisted with each other. In a case where the transformer 80 is disposed on the front surface 21a, the first sensor line portion 51 and the second sensor line portion 52 between the shunt resistor 50 and the transformer 80, and the transformer 80 on the front surface 21a may be surrounded by an electromagnetic shield.

The present disclosure is not limited to the above-described examples, and various modifications can be made. In the embodiment and the respective modification examples, a case where the first power line portion and the second power line portion are drawn out from the top plate on an upward side to the outside of the casing has been exemplified. However, the first power line portion and the second power line portion may be drawn out from a side plate on a lateral side to the outside of the casing. **In** the embodiment and the respective modification examples, a case where the shape of the heat dissipation plate on which the semiconductor element is disposed is a flat plate shape has been exemplified. However, the shape of the heat dissipation plate may be another shape (for example, a U-shape) without limitation to the flat plate shape. The heat dissipation plate may have a cooling hole for causing a coolant to pass through in addition to the through-hole. In this case, the cooling hole may be made of an insulating material such as a resin. Heat dissipation fins for exchanging heat with the coolant may be formed in the heat dissipation plate. In this case, the heat dissipation fins may be made of a material with high thermal conductivity and low electrical conductivity (for example, graphite). The cover may be made of a conductive material such as a metal material without limitation to a resin material.

The first sensor line portion and the second sensor line portion may not be directly connected to the shunt resistor. The first sensor line portion and the second sensor line portion may be connected to the shunt resistor through another element. Specifically, in the example shown in FIG. 2, the first sensor line portion 51 may be connected to the wire 42a and electrically connected to the shunt resistor 50 through the wire 42a. Similarly, the second sensor line portion 52 may be connected to the wire 42b and electrically connected to the shunt resistor 50 through the second power line portion 42.

The power semiconductor module includes the shunt resistor for measuring an electric current as the sensor element. However, there is no limitation, and the power semiconductor module may include other sensor elements such as a Hall element. Even in this case, in the power semiconductor element and a sensor element other than the shunt resistor, a digit number of a value of handled electric power is significantly different. Even in such a case, the power semiconductor module can suppress a detection signal of the sensor element from being affected by radiation noise.

At least parts of the embodiments and the various modification examples may be arbitrarily combined.

Hereinafter, the gist of the present disclosure will be described.
[1] A power semiconductor module, including:
   a power semiconductor element that includes a first electrode, a second electrode, and a control electrode, and alternately switches conduction and non-conduction between the first electrode and the second electrode in response to a control signal applied to the control electrode;
   a first power line portion and a second power line portion respectively electrically connected to the first electrode and the second electrode, and transmit electric power between the first electrode and the second electrode;
   a heat dissipation plate that has a front surface on which the power semiconductor element is mounted, and a rear surface opposite to the front surface, and is configured to dissipate heat from the power semiconductor element;
   a sensor element mounted on the front surface of the heat dissipation plate; and
   a first sensor line portion and a second sensor line portion electrically connected to the sensor element,
   wherein the heat dissipation plate includes a shield layer made of a material having at least one of electrical conductivity and magnetism,
   the heat dissipation plate has at least one through-hole passing through between the front surface and the rear surface, and
   among the first power line portion, the second power line portion, the first sensor line portion, and the second sensor line portion, only the first sensor line portion and the second sensor line portion are drawn out to a region on the rear surface of the heat dissipation plate through the through-hole.
[2] The power semiconductor module according to [1],
   wherein the sensor element is a shunt resistor for current measurement, and is electrically connected in series to a middle portion of the second power line portion.
[3] The power semiconductor module according to [2],
   wherein the shunt resistor is mounted on the front surface of the heat dissipation plate, and
   the heat dissipation plate is configured to dissipate heat from the shunt resistor.
[4] The power semiconductor module according to any one of [1] to [3],
   wherein the at least one through-hole is formed at a position that does not overlap the first power line portion and the second power line portion in a plan view of the heat dissipation plate.
[5] The power semiconductor module according to any one of [1] to [4],
   wherein the heat dissipation plate has the one through-hole, and
   the first sensor line portion and the second sensor line portion are drawn out to the region on the rear surface through the one through-hole.
[6] The power semiconductor module according to [5],
   wherein the first sensor line portion and the second sensor line portion are drawn out to the region on the rear surface through the one through-hole in a state of being twisted with each other.
[7] The power semiconductor module according to [5] or [6],
   wherein the first sensor line portion and the second sensor line portion include a common mode filter or a transformer capable of removing a common mode component of a conduction noise conducting through the first sensor line portion and the second sensor line portion, and
   the common mode filter or the transformer is disposed inside the one through-hole.
[8] The power semiconductor module according to any one of [1] to [7], further including:
   a cylindrical electromagnetic shield that is disposed to surround the first sensor line portion between an end on a sensor element side in the first sensor line portion and an opening of the one through-hole on the surface, and includes a shield layer made of a material having at least one of electrical conductivity and magnetism.
[9] The power semiconductor module according to any one of [1] to [4], and [8],
   wherein the heat dissipation plate has a first through-hole and a second through-hole formed at different positions on the front surface as the through-hole,
   the first sensor line portion is drawn out to the region on the rear surface through the first through-hole, and
   the second sensor line portion is drawn out to the region on the rear surface through the second through-hole.
[10] The power semiconductor module according to any one of [1] to [9],
   wherein the at least one through-hole is formed at a position overlapping the sensor element in a plan view of the heat dissipation plate.
[11] The power semiconductor module according to any one of [1] to [10], further including:
   a cover configured to cover the front surface of the heat dissipation plate on which the power semiconductor element is mounted,
   wherein the first power line portion and the second power line portion extend toward the cover from the first electrode and the second electrode, and are drawn out through the cover to the outside of the region covered with the cover.
[12] The power semiconductor module according to [11],
   wherein the cover includes a side wall portion, and a top plate facing the front surface with the side wall portion interposed between the front surface and the top plate, and
   the first power line portion and the second power line portion extend toward the top plate from the first electrode and the second electrode, and are drawn out through the top plate to the outside of the region covered with the cover.
[13] A power conversion device, including:
   a power conversion unit that includes the power semiconductor module according to any one of [1] to [12], and converts a first power mode supplied from a power source to a second power mode required for a load device; and
   a controller configured to transmit a control signal to the power semiconductor module based on a detection signal of the sensor element.

### Reference Signs List

1: power conversion device, 2: switch circuit (power conversion unit), 3: control substrate (controller), 5, 5A, 5B, 5C, 5D, 5E, 5F: power semiconductor module, 10, 10A, 10B, 10C, 10D, 10E, 10F: power semiconductor element, 11: drain electrode (first electrode), 12: source electrode (second electrode), 13: gate electrode (control electrode), 20: casing, 21, 21A, 21C, 21E: heat dissipation plate, 21a: front surface, 21b: rear surface, 22: cover, 22a: top plate, 22b: side plate (side wall portion), 41: first power line portion, 42: second power line portion, 50: shunt resistor (sensor element), 51: first sensor line portion, 52: second sensor line portion, 61: first magnetic shield (electromagnetic shield), 62: second magnetic shield (magnetic shield), 70: common mode filter, 80: transformer, B: power source, E1: control signal, E2: electric power, H10, H40, H50, H60: through-hole, H20: first through-hole, H30: second through-hole, H40: through-hole, M: load device, N: radiation noise, R1, R2: region.

## Claims

1. A power semiconductor module, comprising:
a power semiconductor element that comprises a first electrode, a second electrode, and a control electrode, and alternately switches conduction and non-conduction between the first electrode and the second electrode in response to a control signal applied to the control electrode;
a first power line portion and a second power line portion respectively electrically connected to the first electrode and the second electrode, and configured to transmit electric power between the first electrode and the second electrode;
a heat dissipation plate that comprises a front surface on which the power semiconductor element is mounted, and a rear surface opposite to the front surface, and is configured to dissipate heat from the power semiconductor element;
a sensor element mounted on the front surface of the heat dissipation plate; and
a first sensor line portion and a second sensor line portion electrically connected to the sensor element,
wherein the heat dissipation plate comprises a shield layer made of a material having at least one of electrical conductivity and magnetism,
wherein the heat dissipation plate comprises at least one through-hole passing through between the front surface and the rear surface, and
wherein among the first power line portion, the second power line portion, the first sensor line portion and the second sensor line portion, the first sensor line portion and the second sensor line portion are drawn out to a region on the rear surface of the heat dissipation plate through the through-hole.

2. The power semiconductor module according to claim 1,
wherein the sensor element is a shunt resistor for current measurement, and is electrically connected in series to a middle portion of the second power line portion.

3. The power semiconductor module according to claim 2,
wherein the shunt resistor is mounted on the front surface of the heat dissipation plate, and
wherein the heat dissipation plate is configured to dissipate heat from the shunt resistor.

4. The power semiconductor module according to claim 1,
wherein the at least one through-hole is formed at a position that does not overlap the first power line portion or the second power line portion in a plan view of the heat dissipation plate.

5. The power semiconductor module according to claim 1,
wherein the heat dissipation plate comprises a single through-hole, and
wherein the first sensor line portion and the second sensor line portion are drawn out to the region on the rear surface through the one through-hole.

6. The power semiconductor module according to claim 5,
wherein the first sensor line portion and the second sensor line portion are drawn out to the region on the rear surface through the one through-hole in a state of being twisted with each other.

7. The power semiconductor module according to claim 5,
wherein the first sensor line portion and the second sensor line portion comprise a common mode filter or a transformer configured to remove a common mode component of a conduction noise conducting through the first sensor line portion and the second sensor line portion, and
wherein the common mode filter or the transformer is disposed inside the one through-hole.

8. The power semiconductor module according to claim 5, further comprising:
a cylindrical electromagnetic shield that is disposed to surround the first sensor line portion between an end of the first sensor line portion on a side of the sensor element and an opening of the through-hole on the front surface, and comprises a shield layer made of a material having at least one of electrical conductivity and magnetism.

9. The power semiconductor module according to claim 1,
wherein the heat dissipation plate comprises a first through-hole and a second through-hole formed at different positions on the front surface as the through-hole,
wherein the first sensor line portion is drawn out to the region on the rear surface through the first through-hole, and
wherein the second sensor line portion is drawn out to the region on the rear surface through the second through-hole.

10. The power semiconductor module according to claim 1,
wherein the at least one through-hole is formed at a position overlapping the sensor element in a plan view of the heat dissipation plate.

11. The power semiconductor module according to claim 1, further comprising a cover covering the front surface of the heat dissipation plate on which the power semiconductor element is mounted,
wherein the first power line portion and the second power line portion extend toward the cover from the first electrode and the second electrode, and are drawn out through the cover to the outside of the region covered with the cover.

12. The power semiconductor module according to claim 11,
wherein the cover comprises a side wall portion, and a top plate facing the front surface with the side wall portion interposed between the front surface and the top plate, and
wherein the first power line portion and the second power line portion extend toward the top plate from the first electrode and the second electrode, and are drawn out through the top plate to the outside of the region covered with the cover.

13. A power conversion device, comprising:
a power converter that comprises the power semiconductor module according to any one of claims 1 to 12, and converts a first power mode supplied from a power source to a second power mode for a load device; and
a controller configured to transmit a control signal to the power semiconductor module based on a detection signal of the sensor element.
